# EUROPEAN PATENT APPLICATION

(11) **EP 4 734 696 A1**
(43) Date of publication of application: **29.04.2026**
(21) Application number: 25168198.7
(22) Date of filing: 03.04.2025
(51) Int. Cl.: H10D 10/01, H10D 10/80, H10D 62/80, H10D 62/17, H10D 62/815

(54) **STRUCTURE WITH PORTIONS HAVING DIFFERENT GERMANIUM CONCENTRATIONS AND RELATED METHODS**

(30) Priority: 23.10.2024 US 202418924466
(71) Applicant: GlobalFoundries U.S. Inc., Malta, NY 12020 (US)
(72) Inventor: Raghunathan, Uppili S., Essex Junction, 05452 (US); Luce, Cameron, Essex Junction, 05452 (US); Krishnasamy, Rajendran, Essex Junction, 05452 (US); Hazbun, Ramsey M., Essex Junction, 05452 (US); Jain, Vibhor, Malta, 12020 (US); Derrickson, Alexander M., Malta, 12020 (US); Shank, Steven M., Essex Junction, 05452 (US)
(74) Representative: Grünecker Patent- und Rechtsanwälte PartG mbB

(57) **Abstract**

The disclosure provides a structure base portions having different germanium concentrations, and related methods. A structure of the disclosure includes a base region including a first portion on a first emitter/collector (E/C) terminal and including germanium (Ge). A Ge concentration in the first portion varies with respect to distance from the first E/C terminal. A second portion is on the first portion and includes Ge. A third portion is between the second portion and a second E/C terminal and includes Ge. A Ge concentration in the third portion varies with respect to distance between the second portion and the second E/C terminal.

## Description

### BACKGROUND

The present disclosure relates to bipolar transistor structures and methods to form such structures.

Present technology is at atomic level scaling of certain micro-devices such as logic gates, bipolar transistors, field effect transistors (FETs), and capacitors. Circuit chips with millions of such devices are common. The structure of a bipolar transistor defines several of its properties during operation. Bipolar transistors typically include multiple materials within its base terminal, i.e., the terminal for controlling current flow between the emitter and collector terminals of the bipolar transistor. The base terminal of a bipolar transistor includes doped semiconductor material having an opposite polarity from, and located between, the emitter and collector. Physical attributes of the base influence the speed of a bipolar transistor, and such attributes in turn may arise from processing techniques (e.g., thermal annealing) to form the bipolar transistor. Certain higher temperature and/or lengthier processing operations may cause undesirable amounts of dopant diffusion from one part of the transistor to another.

### SUMMARY

The illustrative aspects of the present disclosure are designed to solve the problems herein described and/or other problems not discussed.

Embodiments of the disclosure provide a structure including: a base region including: a first portion on a first emitter/collector (E/C) terminal and including germanium (Ge), wherein a Ge concentration in the first portion varies with respect to distance from the first E/C terminal, a second portion on the first portion and including Ge, and a third portion between the second portion and a second E/C terminal and including Ge, wherein a Ge concentration in the third portion varies with respect to distance between the second portion and the second E/C terminal.

Other embodiments of the disclosure provide a structure including: a base vertically between an emitter and a collector of a bipolar transistor, wherein the base includes: a first portion on the collector and including germanium (Ge), wherein a Ge concentration in the first portion varies with respect to distance from the collector, a second portion on the first portion and including Ge and a dopant having a different conductivity type from a conductivity type of the emitter and the collector of the bipolar transistor, and a third portion between the second portion and the emitter and including Ge, wherein a Ge concentration in the third portion varies with respect to distance between the second portion and the emitter.

Further embodiments of the disclosure provide a method including: forming a base region, wherein forming the base region includes: forming a first portion on a first emitter/collector (E/C) terminal and including germanium (Ge), wherein a Ge concentration in the first portion varies with respect to distance from the first E/C terminal, forming a second portion on the first portion and including Ge, and forming a third portion between the second portion and a second E/C terminal and including Ge, wherein a Ge concentration in the third portion varies with respect to distance between the second portion and the second E/C terminal.

### BRIEF DESCRIPTION OF THE DRAWINGS

These and other features of this disclosure will be more readily understood from the following detailed description of the various aspects of the disclosure taken in conjunction with the accompanying drawings that depict various embodiments of the disclosure, in which:
FIG. 1 depicts a cross-sectional view of a structure according to embodiments of the disclosure.
FIG. 2 depicts an expanded cross-sectional view of a base region within a structure according to embodiments of the disclosure.
FIG. 3 depicts an example plot of germanium concentration relative to position in structures according to embodiments of the disclosure.
FIG. 4 depicts another example plot of germanium concentration relative to position in structures according to embodiments of the disclosure.
FIG. 5 depicts an expanded cross-sectional view of a base region between an emitter and collector in a structure according to further embodiments of the disclosure.
FIG. 6 depicts an example plot of germanium concentration relative to position in structures according to further embodiments of the disclosure.
FIG. 7 another expanded cross-sectional view of a base region within a structure having an opposite polarity according to embodiments of the disclosure.
FIG. 8 depicts an expanded cross-sectional view of a base region between an emitter and collector in a structure according to still further embodiments of the disclosure.
FIGS. 9 provides an illustrative flow diagram of methods to form a structure according to embodiments of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which is shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (a) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

The disclosure provides a structure base portions having different germanium concentrations, and related methods. A structure of the disclosure includes a base region including a first portion on a first emitter/collector (E/C) terminal and including germanium (Ge). A Ge concentration in the first portion varies with respect to distance from the first E/C terminal. A second portion is on the first portion and includes Ge. A third portion is between the second portion and a second E/C terminal and includes Ge. A Ge concentration in the third portion varies with respect to distance between the second portion and the second E/C terminal.

Bipolar junction transistor (BJT) structures, such as those in embodiments of the disclosure, operate using multiple "P-N junctions." The term "P-N" refers to two adjacent materials having different types of conductivity (i.e., P-type and N-type), which may be induced through dopants within the adjacent material(s). A P-N junction, when formed in a device, may operate as a diode. A diode is a two-terminal element, which behaves differently from conductive or insulative materials between two points of electrical contact. Specifically, a diode provides high conductivity from one contact to the other in one voltage bias direction (i.e., the "forward" direction), but provides little to no conductivity in the opposite direction (i.e., the "reverse" direction). In the case of the P-N junction, the orientation of a diode's forward and reverse directions may be contingent on the type and magnitude of bias applied to the material composition of one or both terminals, which affects the size of the potential barrier. In the case of a junction between two semiconductor materials, the potential barrier will be formed along the interface between the two semiconductor materials. Generally, a BJT structure includes a base region vertically or horizontally between emitter and collector materials. A BJT can be either a PNP-type BJT or an NPN-type BJT. In a PNP-type BJT, the emitter and collector regions have P-type conductivity and at least a portion of the base region has N-type conductivity. In an NPN-type BJT, the emitter and collector regions have N-type conductivity and at least a portion of the base has P-type conductivity.

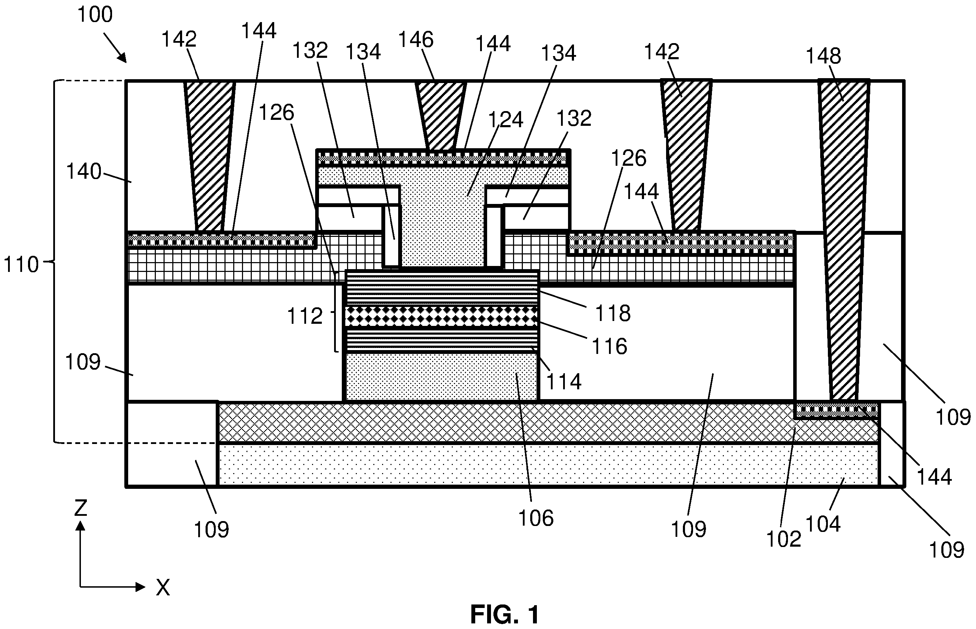

Referring to FIG. 1, a structure 100 according to the disclosure may include a bipolar transistor 110 (e.g., a vertically oriented bipolar transistor as discussed herein). Bipolar transistor 110 of structure 100 may be formed on a subcollector 102 (i.e., a doped portion of a semiconductor substrate) including, e.g., one or more monocrystalline semiconductor materials. Subcollector 102 may include but is not limited to silicon, germanium, silicon germanium (SiGe), silicon carbide, or any other common IC semiconductor substrates. In the case of SiGe, the germanium concentration in subcollector 102 may differ from other SiGe-based structures described herein. A portion or entirety of subcollector 102 may be strained. Subcollector 102 may be doped (i.e., it may define a "doped well" ), e.g., to enable coupling to the lower active semiconductor materials of a vertical bipolar transistor. Subcollector 102 may have any conceivable doping type and/or doping composition appropriate for use within and/or coupling to the collector terminal of a bipolar transistor. For instance, subcollector 102 may have the same dopant type as a collector 106 formed thereon, e.g., P-type doping in the case of a PNP-type **BJT** or N-type doping in the case of an NPN-type **BJT,** and/or may have a higher or lower dopant concentration therein.

Collector 106 may be on subcollector 102, e.g., as a single layer or multiple similarly doped but distinct layers formed by epitaxial deposition of silicon, SiGe, and/or other semiconductor materials on subcollector 102 and may have a predetermined doping type, e.g., by being doped in-situ or during formation of semiconductor material(s) of subcollector 102 and/or subcollector 102. Collector 106 alternately may be known as a "first emitter/collector (E/C)" terminal to indicate that its position may be reversed with emitter 124, discussed elsewhere herein. Collector 106 is monocrystalline in structure. Collector 106 may define active semiconductor material of a vertical bipolar transistor, and thus may be vertically below other terminals (i.e., intrinsic base, extrinsic base, and emitter terminals discussed herein) of bipolar transistor **110.** Collector 106 may have various structural characteristics based on the process(es) to form collector 106 and other components thereon. Collector 106 is shown as being substantially rectangular, but alternatively may have other geometries such as a rounded profile, a trapezoidal profile, and/or other shapes. Collector 106 may be formed by combinations of deposition, epitaxial growth, selective or non-selective etching, and/or other techniques.

Isolation layer 109, which optionally may be subdivided into multiple layers and/or materials of varying width and/or depth, may also be on and/or adjacent subcollector 102 and substrate 104 to horizontally separate various active semiconductor materials on substrate 104. As shown, some isolation layers 109 may extend vertically into substrate 104, whereas others may be located on subcollector 102 to prevent electrical shorting between subcollector 102 and overlying areas of bipolar transistor 110. As discussed elsewhere herein isolation layer 109 initially may extend over substrate 104 as a single layer. Portions of isolation layer 109 may be removed to form a trench, which optionally may undercut certain remaining portions of isolation layer 109 near subcollector 102

Bipolar transistor 110 may include a base region 112, also known as an "intrinsic base," on collector 106. Base region 112 may include, e.g., monocrystalline SiGe as discussed herein or other silicon and/or other semiconductor-based materials. Base region 112, in addition to base material in the form of SiGe, may include various additional subcomponents and/or layers with varying composition and/or doping as discussed herein. Specifically, base region 112 may include a first portion 114 on collector 106, a second portion 116 on first portion 114, and a third portion 118 vertically between second portion 116 and emitter 124 thereover. Second portion 116 may be a doped region (e.g., a region doped with a dopant having a predetermined conductivity type ("polarity")), e.g., it may be doped P type in the case where collector 106 and an emitter 124, thereover, are doped N type and vice versa. Emitter 124 alternately may be known as a "second emitter/collector (E/C)" terminal to indicate that its position may be reversed with collector 106, discussed elsewhere herein. The use of differing semiconductor materials at the emitter-base junction and at the base-collector junction creates heterojunctions, which are, for example, suitable for handling higher frequencies. In this case, the BJT is referred to in the art as a heterojunction bipolar transistor (HBT). In the case where the bipolar transistor is an NPN-type transistor and subcollector 102, collector 106, and emitter 124 are doped n-type, second portion 116 of base region 112 may be doped p-type to form a P-N junction, and hence a base-to-collector interface. It is also understood that second portion 116 of base region 112 may be doped n-type in the case where the bipolar transistor is a PNP-type transistor. However embodied, base region 112 may extend to a predetermined height over collector 106 and may have a similar profile to collector 106 thereunder in the case where base region 112 is formed by epitaxial growth and/or similar techniques.

As discussed herein, base region 112 may be structurally and compositionally distinct from other portions of a base terminal by having certain materials that are only lightly doped (e.g., second portion 116) and other materials with varying amounts of germanium (Ge) and still lower doping concentrations (e.g., possibly undoped), e.g., as discussed herein regarding various embodiments of first portion 114 and third portion 118. An extrinsic base 126 on base region 112 (e.g., adjacent emitter 134 and isolated therefrom) may be doped more highly than base region 112. Base region 112 may be formed, e.g., by forming a layer of semiconductor material, which may be monocrystalline silicon or SiGe as discussed herein, on collector 106. Additional portions of base region 112 may be formed through selective epitaxial growth and/or similar processes while preserving the crystallographic orientation and/or composition of the underlying material(s).

Extrinsic base(s) 126 of bipolar transistor 110 may be on respective portions of base region 112 (e.g., on third portion 118 thereof). Extrinsic base(s) 126 may include a polycrystalline semiconductor (e.g., polycrystalline SiGe) with a relatively high amount of the same doping type as (e.g., more p-type doping than) dopants within base region 112 (e.g., within second portion 116 thereof). Extrinsic base(s) 126 may be formed, e.g., by depositing an initial (seed) layer of monocrystalline and/or other semiconductor materials on base region 112. Through selective epitaxial growth, deposition, and/or other processing, extrinsic base(s) 126 can be formed from the initial layer to a desired height.

Emitter 124 may be on base region 112 in a position horizontally spaced between extrinsic base(s) 126. In an example, emitter 124 may be horizontally between two extrinsic bases 126. Emitter 124 may be on base region 112, e.g., by forming a stack of materials including portions of extrinsic base(s) 126 over base region 112, removing a portion of the stack of materials, and forming emitter 124 and/or other components within and/or in place of the removed extrinsic base 126 material. Emitter 124 may have the same doping type as subcollector 102 and collector 106, and thus, has an opposite doping type relative to extrinsic base 126 (and second portion 116 of base region 112). In the case where bipolar transistor 110 is an NPN device, collector 106 and emitter 124 may be doped n-type to provide the two n-type active semiconductor materials and base region 112 (e.g., second portion 116 thereof) may be doped p-type. Emitter 124 may include polycrystalline silicon and/or other monocrystalline semiconductor materials, including one or more materials used elsewhere in structure 100 to form subcollector 102, collector 106, extrinsic base 126 (with different doping), etc.

One or more spacers, e.g., a first spacer 132 and a second spacer 134, may be adjacent emitter 124 to structurally and electrically separate emitter 124 from extrinsic base(s) 126 and/or contacts formed thereto. First spacer 132 and second spacer 134 may have different compositions to control (e.g., increase) the electrical insulation between emitter 124 and nearby portions of extrinsic base 126. For instance, first spacer 132 may be a nitride based insulator formed alongside remaining portions of base region 112 and second spacer 134 may be an oxide based insulator formed on first spacer 132. These example compositions of first spacer 132 and second spacer 134 may be reversed in alternate configurations. Optionally, alternative configurations of first spacer 132 and/or second spacer 134 may be formed to provide a particular arrangement of insulative materials between extrinsic base 126 and emitter 124. Other compositions and/or arrangements of spacers 132, 134 currently known or later developed also may be used. Spacer(s) 132, 134 thus may include oxide materials, nitride materials, and/or any other insulative material discussed herein, e.g., compositions similar to isolation layer 109 or other insulating structures. Spacer(s) 132, 134 be formed, e.g., by depositing layers of spacer material as part of a stack, removing portions of the stack where emitter 124 is desired, and optionally forming additional portions of spacer 132, 134 material to cover any exposed surfaces and inner sidewalls of extrinsic base 126 before other materials (e.g., emitter 124) are formed adjacent spacers 132, 134 and on a desired portion of base region 112. In some implementations, spacer(s) 132, 134 may include a single layer or more than two layers.

Structure 100 may include an inter-level dielectric (ILD) layer 140 over isolation layer 109, extrinsic bases 126, emitter 124, spacers 132, 134, etc. ILD layer 140 may include the same insulating material as isolation layer 109 or may include a different electrically insulative material for vertically separating active materials from overlying materials, e.g., various horizontally extending wires or vias. ILD layer 140 and isolation layer 109 nonetheless constitute different components, e.g., due to isolation layer 109 being vertically between subcollector 102 and the various active components of structure 100. ILD layer 140 may be formed by deposition and/or other techniques to provide electrically insulating materials, and can then be planarized (e.g., using CMP), such that its upper surface remains above any active components formed on subcollector 102.

A set of base contacts 142 through ILD layer 140 may provide the vertical electrical coupling to extrinsic base 126 from overlying metal wires and/or vias. Base contacts 142, notably, do not extend to base region 112. Base region 112 and subcomponents thereof thus are coupled to base contacts 142 only through extrinsic base 126. Some portions of extrinsic base 126 may be converted into a silicide layer 144 to improve conductivity between each base contact 142 and any portions of extrinsic base 126 thereunder, e.g., by providing a conductive metal such as cobalt (Co), titanium (Ti), nickel (Ni), platinum (Pt), or similar material on the upper surface(s) of a targeted material. The conductive material(s) may be annealed while in contact with the underlying semiconductor to produce silicide layer 144 for electrically coupling semiconductor materials to any contacts formed thereon. Excess conductive material can then be removed using any now known or later developed solution, e.g., etching.

Structure 100 also includes an emitter contact 146 to emitter 124 and a collector contact 148 to collector 106 through subcollector 102. Each contact 146, 148 also may be coupled to emitter 124 or subcollector 102, respectively, through silicide layers 144 formed therein. Each contact 146 also may extend through ILD layer 140, thus collecting active semiconductor material within subcollector 102 or emitter 124 to overlying metal wires, vias, etc., above structure 100. Contact(s) 142, 146, 148 optionally may be formed as part of a single operation, e.g., by removing portions of ILD layer 140 to form openings, forming silicide layers 144 on semiconductor materials exposed within the openings, and filling the openings with metal to define each contact 142, 146, 148. One or more of contacts 142, 146, 148 may include refractory metal liners (not separately shown) on their sidewalls to impede or prevent electromigration degradation, shorting to other components, etc.

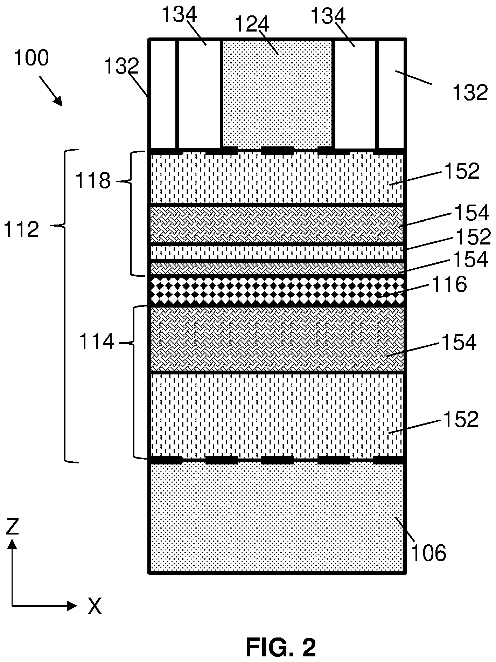

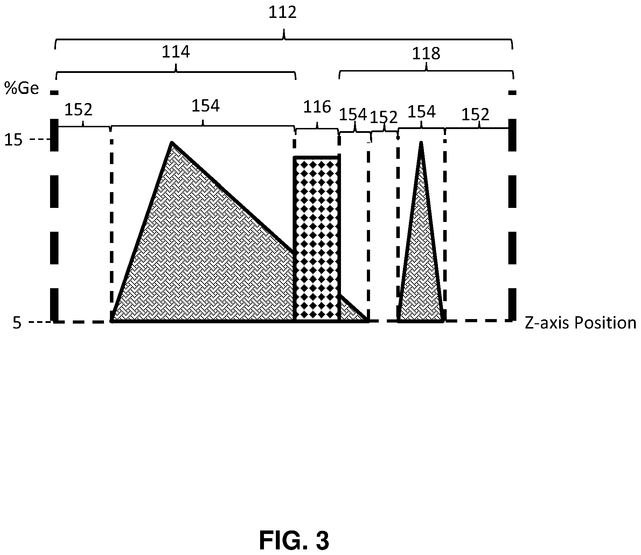

Referring to FIGS. 2 and 3 together, in which FIG. 2 provides an expanded view of base region 112 between collector 106 and emitter 124, and in which FIG. 3 provides a plot of germanium concentration relative to position along Z-axis, further features of base region 112 are discussed. According to a first example, base region 112 may be structured for implementation in an NPN bipolar transistor, i.e., second portion 116 of base region 112 is lightly doped P type whereas collector 106 and emitter 124 are both more heavily doped N type. Extrinsic base(s) 126 may be more heavily doped P type, but base region 112 differs from conventional bipolar transistors by including additional structural features and/or doping characteristics. As shown in the expanded view of FIG. 2, base region 112 is subdivided into first portion 114, second portion 116, and third portion 118. First portion 114 and third portion 118 themselves may be subdivided into first segments 152 and second segments 154, differentiated by their relative amounts of germanium (Ge). First segments 152 in an example may be low Ge material having Ge concentrations below a certain threshold (e.g., a concentration of at most approximately five percent Ge), and either no dopant material(s) and/or less than a threshold concentration (e.g., approximately five percent) of dopant material(s). Second segments 154 also may include germanium, and moreover may have the same or similar material composition(s) as first segment(s) 152 but may instead feature high Ge concentrations. Second segment(s) 154 may have Ge concentrations above the threshold for first segment(s) 152 (e.g., five percent Ge or more) and may have varying Ge concentrations up to approximately fifteen percent or another peak percentage. Second segment(s) 154 each may have "peaking" Ge concentrations, i.e., they may rise from a lower concentration to a peak concentration before declining back to the lower concentration. Segments 152, 154 otherwise may include semiconductor material(s), e.g., silicon (Si) in various configurations and/or silicon germanium (SiGe).

As shown specifically in FIG. 3, first portion 114 and third portion 118 have nonuniform, positionally dependent concentrations of Ge therein. Second segments 154 in each portion 114, 118 may have Ge concentrations greater than the Ge concentration in first segments 152. Any portions of base region 112 having a Ge concentration of less than a threshold value (e.g., approximately five percent Ge) may be considered to be part of first segment(s) 152 and not second segment(s) 154 in this example. Relative to Z-axis position, the concentration of Ge in each first portion 114 and third portion 118 may follow a rising and falling trendline. In the example of FIG. 3, the Ge concentration trendline for each first portion 114 and third portion 118 may be substantially triangular. In second segment 154 of first portion 114, Ge concentration rises substantially linearly from an initial minimum (e.g., approximately five percent Ge) to a maximum concentration (e.g., approximately fifteen percent Ge or otherwise approximately at least three times the threshold Ge concentration). The Ge concentration in second segment 154 of first portion 114 then may decline relative to position (e.g., distance from collector 106 as it approaches second portion 116 substantially linearly or according to other profiles) from its maximum concentration to the minimum concentration. Second portion 116 may differ from first portion 114 and third portion 118 by having a substantially uniform dopant concentration as discussed elsewhere herein.

Third portion 118 on second portion 116 may have substantially similar minimum and maximum Ge concentrations to first portion 114. These concentrations, while positionally dependent, may follow a different trendline. For example, where third portion 118 includes second segment(s) 154 smaller than that of first portion 114, the Ge concentration within second segment(s) 154 of third portion 118 rise more rapidly from its minimum value to its maximum value and may similarly decline along a steeper trendline. The change in Ge concentration relative to position may be controlled, e.g., by adjusting the process(es) such as epitaxial growth, material deposition, etc., used to form portions 114, 118. Although first portion 114 and third portion 118 each may have approximately the same maximum Ge concentration, in various other embodiments they may have unequal Ge concentrations. For instance, second segment(s) 154 in third portion 118 may have between approximately fifty percent and approximately one-hundred percent of the maximum Ge concentration than second segment(s) 154 in first portion 114. Such differences may be chosen, e.g., to fine tune or further reduce the amount of dopant diffusion from second portion 116 in various applications.

Second portion 116 of base region 112 may have varying Ge concentration with a substantially uniform doping concentration, and thus may include one or more dopants therein. The composition of second segment 116, particularly any dopant species therein, may depend on the composition and/or polarity of bipolar transistor 110 (FIG. 1) where base region 112 is implemented. Second portion 116 is shown with different cross-hatching in FIGS. 2 and 3 to further indicate a different material composition and/or presence of dopants as compared to first portion 114 and third portion 118. Second portion 116 may include, e.g., SiGe or other semiconductor materials together with dopants selected to provide a desired polarity. In the case of an NPN bipolar transistor, second portion 116 may include SiGe doped with Boron (B) or other P-type dopants to a particular concentration. The Ge concentration in second portion 116 may be substantially uniform, and in particular may be larger than any low-Ge segments within first portion 114 or third portion 118. Second portion 116 also may have a substantially uniform (i.e., not location-dependent) concentration of dopants (e.g., B) therein.

Second portion 116 may be positioned immediately between, and perhaps in physical contact with, second segments 154 of each portion 114, 118. In other embodiments, a first segment 152 may separate second portion 116 from second segment(s) 154 within first portion 114 or third portion 118. Nonetheless, second portion 116 may be located "between" two second segments 154 (i.e., high Ge materials as discussed herein) regardless of whether first segment(s) 152 is/are also present. Second segment(s) 154 of each portion 114, 118 each may physically impede or even block dopants from migrating out of second portion 116 into other portions of base region 112 during manufacture (e.g., annealing or other thermal processing) when forming bipolar transistor 110. In other embodiments with different polarities, first segment(s) 152 may provide this function, i.e., they may impede dopant diffusion in the case of a PNP transistor (where Si may suppress N-type dopant diffusion). Thus, First portion 114 and third portion 118, singularly or collectively, substantially confine all dopants within base region 112 to physical space within second portion 116. These characteristics of first portion 114, second portion 116, and third portion 118 thus may prevent dopant diffusion from base region 112 into active or inactive components located near base region 112. In various further embodiments, such characteristics and benefits can be achieved by locating second segments 154 anywhere between the location of second portion 116 and the boundary between base region 112 and collector 106 (FIGS. 1, 2) or the boundary between base region 112 and emitter 124 (FIGS. 1, 2).

Regardless of the size, position, and number of segments 152, 154 within each first portion 114 and second portion 118, second segments 154 together may occupy a majority (i.e., at least half) of space available within each segment 114, 118. As shown in the expanded view of base region 112 in FIG. 2, and the plot of material concentrations in FIG. 3, second segment(s) 154 may occupy a majority (i.e., at least half) of the span between collector 106 (FIG .2) and emitter 124. For instance, where base region 112 spans between approximately thirty nanometers (nm) to fifty nanometers nm between collector 106 and emitter 124, second portion 116 may have a span of between approximately one to four nanometers in the same direction and second segments 154 may span between approximately sixteen nanometers to approximately thirty nanometers. In a further example, the individual span of one second segment 154 (e.g., within first portion 114) may be between approximately fifteen nm and twenty-five nm, whereas the span of another second segment (e.g., within third portion 118) may be between approximately one nm and four nm. Various other configurations and/or sizes are possible. In any case, the confining of dopants within second portion 116 may be particularly effective where second segments 154 occupy forty to sixty percent of span between collector 106 and emitter 124, or more specifically, at least fifty percent of the span between collector 106 and emitter 124.

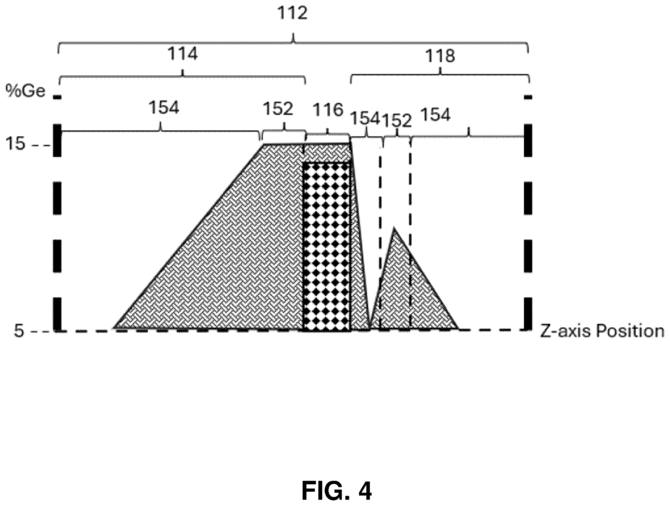

Referring to FIG. 4, an alternative plot of Ge or dopant percentage in base region 112 is shown for another type of bipolar transistor, e.g., a PNP bipolar transistor. PNP bipolar transistors have an opposite polarity relative to NPN configurations, and thus dopants within base material 114 of a PNP bipolar transistor have the opposite effect from dopants in an NPN bipolar transistor. Here, first segments 152 within portions 114, 118 may have a high Ge concentration and second portions 154 instead may feature valleying (i.e., declining and then rising) percent Ge along trendlines oriented in the opposite direction of that of an NPN bipolar transistor. Within first segments 152, the concentration of Ge within the semiconductor material may be substantially uniform (e.g., approximately fifteen percent Ge or seven percent Ge as shown). Within second segments 154, the percent Ge concentration may decline from these value to a minimum concentration, e.g., approximately five percent Ge as shown. The Ge concentration in first segments 152 may vary depending on the bipolar transistor(s) in which they are implemented. Any parts of first portions 114 and/or third portions 118 exceeding a threshold Ge concentration (e.g., approximately sixty percent of the desired maximum Ge concentration for that segment) may be considered part of first segment(s) 152 and thus are not part of second segment(s) 154. The difference in Ge concentration within segments 152, 154 relative to each other may vary across implementations, but in the case of a PNP bipolar transistor, second segments 154 may have Ge concentration less than the percent Ge concentration first segments 152. According to an example, second segments 154 may decline to a percent Ge concentration that is approximately one third of the maximum percent Ge concentration. Segments 152, 154 of first portion 114 and third portion 118 in the implementation of FIG. 4 may be formed substantially similarly to other implementations discussed herein, but with declining percent Ge concentrations instead of increasing percent Ge concentrations.

As with other embodiments, second portion 116 in a PNP bipolar transistor may be positioned between first portion 114 and third portion 118. Second portion 116 may include, e.g., SiGe or other semiconductor materials together with dopants selected to provide a desired polarity. For PNP bipolar transistors, second portion 116 may include SiGe doped with phosphorous (P) or other N-type dopants to a particular concentration. Second portion 116 may not have a substantially uniform (location-dependent) concentration of Ge therein, e.g., due to thermal diffusion even if the as-deposited Ge material may have a substantially uniform concentration. Second portion 116 in some cases also may be directly between second segments 154, i.e., the lower Ge concentration areas of portions 114, 118 in this example. Apart from the relative Ge concentrations in first portion 114 and third portion 118 and the dopant species in second portion 116, base structure 114 otherwise may be similar to other embodiments described herein regardless of whether base material 114 is within an NPN or PNP bipolar transistor. Thus, the configurations shown in FIGS. 1 and 2 may represent either an NPN or PNP bipolar transistor.

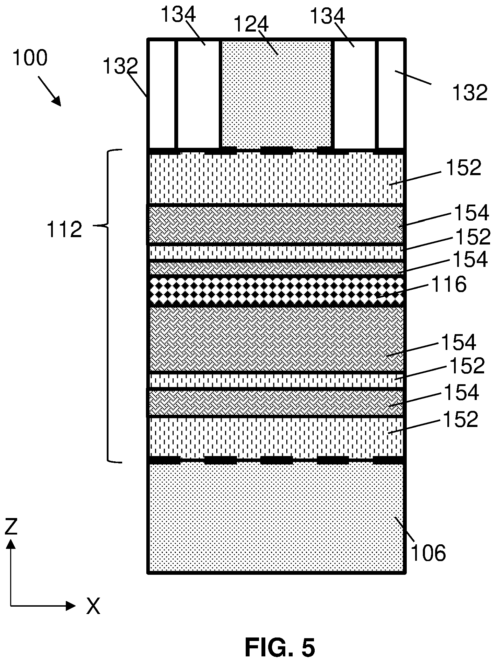

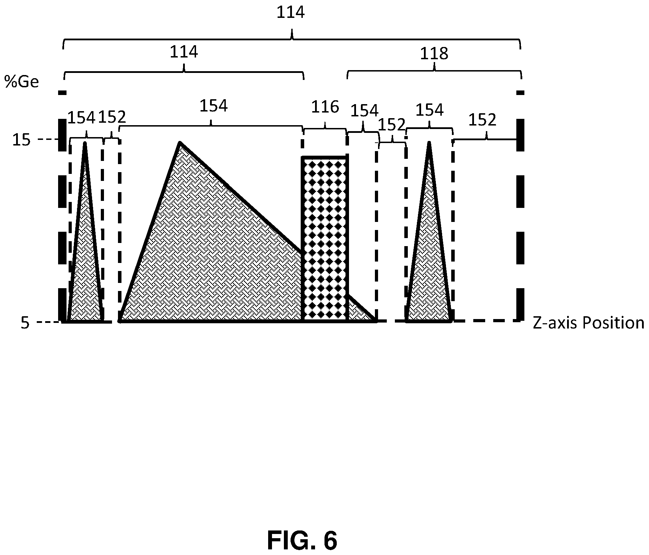

Referring now to FIGS. 5-6 together, further implementations of structure 100 are discussed. FIG. 5 provides an expanded view of base region 112 and FIGS. 6 depict a plot of material concentration relative to Z-axis position. Optionally, structure 100 may include one or more additional second segments 154 within first portion 114 or third portion 118. Additional second segment(s) 154 may provide technical benefits independent of any benefits arising from other second segment(s) 154. During manufacture, dopant diffusion may be more likely to occur in only one direction, e.g., from second portion 116 downward into collector 106.

To further impede or prevent diffusion from base region 112 into collector 106, additional second segment(s) 154 may be present within base material 114 between collector 106 and another second segment 154. At least one second segment 154 completely separates second portion 116 from the additional second segment 154. Apart from further impeding dopant diffusion, additional second segment 154 may provide further electrical benefits by reducing collector-base capacitance within bipolar transistor 110 (FIG. 5). These benefits may not be realized, or even may be impeded, by including additional second segment(s) 154 nearer to emitter 124, regardless of whether bipolar transistor 110 is a PNP or NPN bipolar transistor. Thus, the location, size, and shape of additional second segment(s) 154 may be the same in PNP and NPN bipolar transistors. As with other embodiments discussed herein, additional superlattice material may have an upward-to-downward (i.e., peaking) trend of percent Ge concentrations in an NPN bipolar transistor or may have a downward-to-upward (i.e., valleying) trend of percent Ge concentrations in a PNP bipolar transistor. Second segments 154 of first portion 114 and third portion 118, collectively may feature a substantial "W" shape in an NPN bipolar transistor (See FIG. 6).

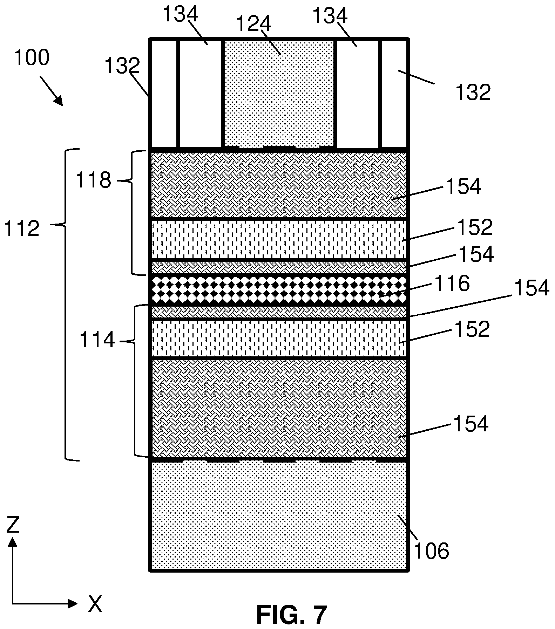

Referring briefly to FIG. 7, structure 100 may have different arrangements of first segments 152 and second segments 154 when providing a PNP bipolar transistor. According to an example, second segments 154 with relatively high Ge concentrations may abut collector 106 and emitter 124, extending inwardly into intrinsic base 112. At least one first segment 152 having a lower Ge concentration may be between a respective second segment 154 and second portion 116. Second portion 116 itself also may be between, and may abut, second segments 154 in first portion 114 and third portion 118. In a PNP configuration, first portion 114 and third portion 118 of structure 100 each include at least one first segment 152 between second segments 154, and second segments 154 define inner and outer areas of each portion 114, 118. These configurations, as shown, may be substantially the opposite of NPN configurations of high and low Ge concentrations for structure 100 discussed elsewhere herein.

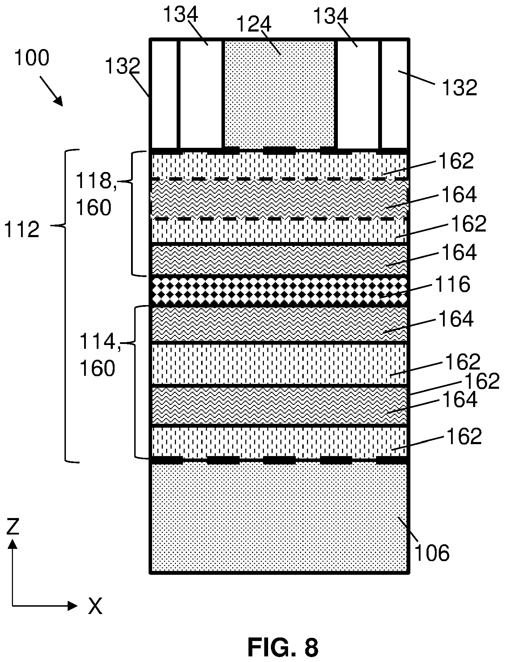

Referring now to FIG. 8, further implementations of structure 100 may include superlattice structures 160 in first portion 114 and third portion 118 instead of variable Ge concentration segments (e.g., first segment(s) 152 and second segment(s) 154 discussed herein and shown in FIGS. 2-6). Superlattice structures 160 each may include sets of semiconductor layers 162, 164 having different Ge concentrations. The terms "superlattice structure" or alternately "superlattice layer," when used herein when referring to superlattice structures 160 and/or semiconductor layers 162, 164 thereof, may refer to layers of material formed from alternating layers of two or more distinct elements and/or compounds. Superlattice structures 160 of base region 112 thus may include semiconductor layers 164 in the form of first SiGe layers each having a first substantially uniform concentration of Ge therein. Semiconductor layers 164, in this case, may alternate with semiconductor layers 162 in the form of intermediate layers each including Si or SiGe layers having a second substantially uniform concentration of Ge substantially less than the first concentration of Ge. According to an example, semiconductor layers 162 may have a Ge concentration of at most approximately five percent. The Ge concentration in each semiconductor layer 162, 164 may be dependent on the process(es) used to form superlattice structures 160. Greater frequency of alternation and/or increasing the size of particular layers may allow a manufacturer to control the percent Ge concentration within semiconductor layers 162, 164 as compared other materials within base region 112.

In addition, one or more of first portion 114 or third portion 118 optionally may include additional semiconductor layers 164 having the first, higher Ge concentration where desired. Such layers 164 may serve a function similar to additional second segments 154 (FIGS. 5-7) discussed herein. However embodied, superlattice structures 160 may be formed a selective semiconductor growth process on underlying materials and/or other portions of base region 112, e.g., using an atomic layer of oxygen deposited in an atomic layer deposition (ALD) tool followed by semiconductor growth or deposition via an appropriate tool (e.g., a chemical vapor deposition (CVD) tool). The equipment used to form superlattice structures 116 may be connected in-situ using a low pressure (vacuum) transfer chamber. Units for manufacture may be transferred back and forth between the tool(s) used to form each layer without breaking the vacuum and to allow sufficient film growth.

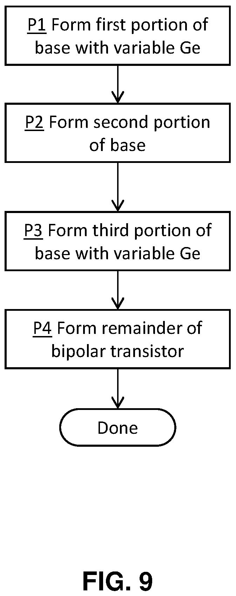

Referring to FIGS. 1, 2, 5, 8, and 9 together, embodiments of the disclosure provide methods to form structure 100, e.g., according to any embodiment or combination of embodiments discussed herein. Process P1 may include, e.g., forming first portion 114 of base region 112 on collector 106. The forming of first portion 114 in process P1 in some cases may include forming only particular segment(s) 152, 154 and/or semiconductor layers 162, 164, with subsequent segment(s) 152, 154 and/or semiconductor layers 162, 164 being formed on the partially completed first portion 114 before additional portions of first portion 114 is/are formed. In other implementations, components such as segment(s) 152, 154 and/or semiconductor layers 162, 164 can be formed by implanting germanium and/or other materials into existing first portion 114, and/or removing portions of first portion 114 for replacement with structures and/or materials discussed herein. In the case where superlattice structures 160 are formed, process P1 may be implemented using a selective semiconductor growth process on underlying materials (e.g., collector 106), e.g., using an atomic layer of oxygen deposited in an atomic layer deposition (ALD) tool followed by semiconductor growth or deposition via an appropriate tool (e.g., a chemical vapor deposition (CVD) tool). Process P1 may be implemented as many times as desired based on the number of layers and/or segments to be formed.

Continued processing may include process P2 of forming second portion 116 on first portion 114, e.g., such that portions 114, 116 are stacked. Second portion 116 may have a similar composition to that of base material 114, e.g., it may include SiGe with a particular dopant species, such as boron or phosphorous, depending on transistor polarity. Second portion 116 may be formed by deposition of semiconductor materials(s) and/or doping by implantation and/or other processes operable to provide semiconductor material with a particular doping type and concentration. In other implementations, second portion 116 may be formed solely by doping of existing semiconductor material located on first portion 114.

Process P3 may include, e.g., forming third portion 118 of base region 112 on second portion 116. The forming of third portion 118 in process P3 may be similar to the forming of first portion 114 in process P1. Forming third portion 118 in some cases may include forming only particular segment(s) 152, 154 and/or semiconductor layers 162, 164, with subsequent segment(s) 152, 154 and/or semiconductor layers 162, 164 being formed on the partially completed third portion 118 before additional portions of third portion 118 is/are formed. In other implementations, components such as segment(s) 152, 154 and/or semiconductor layers 162, 164 can be formed by implanting germanium and/or other materials into existing third portion 118, and/or removing portions of third portion 118for replacement with structures and/or materials discussed herein. In the case where superlattice structures 160 are formed, process P3 may be implemented using a selective semiconductor growth process on underlying materials (e.g., second portion 116), e.g., using an atomic layer of oxygen deposited in an atomic layer deposition (ALD) tool followed by semiconductor growth or deposition via an appropriate tool (e.g., a chemical vapor deposition (CVD) tool). Process P3 may be implemented as many times as desired based on the number of layers and/or segments to be formed.

Methods of the disclosure also include process P4 of forming additional portions (e.g., emitter 124, extrinsic base 126, silicide layer(s) 144, contact(s) 142, 146, 148, ILD 140, etc.) of bipolar transistor 110. Process P4 may be implemented substantially in accordance with conventional techniques to form a bipolar transistor after the forming of base region 112 concludes. After forming bipolar transistor 110, the method then may conclude ("Done"). In various implementations, processes P1-P3 can be implemented with particular materials and/or Ge concentrations to provide a desired transistor polarity (e.g., PNP or NPN as discussed herein) and/or Ge concentrations (e.g., peaking or valleying Ge concentrations, superlattice structures 160, etc., to enable operation and impede dopant diffusions for a particular transistor polarity).

Embodiments of the disclosure provide various technical and commercial advantages, examples of which are discussed herein. As discussed herein, embodiments of the disclosure may impede or altogether prevent dopant migration from base region 112 into other terminals (e.g., collector 106) due to the confining presence of second segments 154 in first portion 116 and third portion 118, and/or superlattice structures 160. In various embodiments, structure 100 may operate with smaller intrinsic base widths than conventional vertical bipolar transistors. Specifically, the reduced risk of dopant migration from the intrinsic base may allow vertical bipolar transistors to function with base widths that are approximately, e.g., thirteen percent smaller than other bipolar transistor structures. Regardless of size, the reduced dopant migration in structure 100 according to the disclosures may substantially reduce base-emitter capacitance, e.g., the capacitance may be approximately thirty percent less than conventional vertical bipolar transistors. These structural and operational benefits may be realized without any reductions in device performance as compared to other vertical bipolar transistor structures.

The method and structure as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about," "approximately," and "substantially," are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In summary, the disclosure provides a structure base portions having different germanium concentrations, and related methods. A structure of the disclosure includes a base region including a first portion on a first emitter/collector (E/C) terminal and including germanium (Ge). A Ge concentration in the first portion varies with respect to distance from the first E/C terminal. A second portion is on the first portion and includes Ge. A third portion is between the second portion and a second E/C terminal and includes Ge. A Ge concentration in the third portion varies with respect to distance between the second portion and the second E/C terminal.

The following embodiments of the above are explicitly disclosed.

### Embodiment 1:

1. A structure comprising:
   a base region including:
   a first portion on a first emitter/collector (E/C) terminal and including germanium (Ge), wherein a Ge concentration in the first portion varies with respect to distance from the first E/C terminal,
   a second portion on the first portion and including Ge, and
   a third portion between the second portion and a second E/C terminal and including Ge, wherein a Ge concentration in the third portion varies with respect to distance between the second portion and the second E/C terminal.

In some illustrative examples of embodiment 1, the second portion may further include a dopant having a different conductivity type from a conductivity type of the first E/C terminal and the second E/C terminal of the bipolar transistor.

In special illustrative examples herein, the dopant may include one of boron (B) or phosphorous (P).

In some illustrative examples of embodiment 1, structure may be a bipolar transistor structure and the first E/C terminal may comprise a collector of a bipolar transistor structure, the second E/C terminal may comprise an emitter of the bipolar transistor structure and the base region may comprise a base of the bipolar transistor structure.

In some illustrative examples of embodiment 1, structure may be a bipolar transistor structure and the first E/C terminal may be a collector of a bipolar transistor structure, the second E/C terminal may be an emitter of the bipolar transistor structure and the base region may be a base of the bipolar transistor structure.

### Embodiment 2:

The structure of embodiment 1, wherein the second portion includes a doped region having a first conductivity type different from a second conductivity type of the first E/C terminal and the second E/C terminal.

### Embodiment 3:

The structure of embodiment 2, wherein a profile of the Ge concentration in the first portion impedes diffusion of a dopant from the doped region to the first E/C terminal, and wherein a profile of the Ge concentration in the third portion impedes diffusion of the dopant from the doped region to the second E/C terminal.

### Embodiment 4:

The structure of one of embodiments 1 to 3, wherein the first portion and the third portion each include superlattice structures of semiconductor layers having different Ge concentrations.

### Embodiment 5:

The structure of embodiment 4, wherein each superlattice structure includes at least:
two first silicon germanium (SiGe) layers each having a first substantially uniform concentration of Ge, and
an intermediate layer between the two SiGe layers, including one of a silicon (Si) layer or an additional SiGe layer having a second substantially uniform concentration of Ge less than the first substantially uniform concentration of Ge.

### Embodiment 6:

The structure of embodiment 5, wherein the second portion includes a second silicon germanium layer with the first substantially uniform concentration of Ge.

### Embodiment 7:

The structure of one of embodiments 1 to 6, wherein the first portion and the third portion each include silicon germanium (SiGe) segments having a spiked Ge concentration profile between the second portion and a respective E/C terminal.

### Embodiment 8:

The structure of one of embodiments 1 to 7, wherein the first portion and the third portion each include silicon germanium (SiGe) segments having a valleyed Ge concentration profile between the second portion and a respective E/C terminal.

### Embodiment 9:

A structure comprising:
a base vertically between an emitter and a collector of a bipolar transistor, wherein the base includes:
a first portion on the collector and including germanium (Ge), wherein a Ge concentration in the first portion varies with respect to distance from the collector,
a second portion on the first portion and including Ge and a dopant having a different conductivity type from a conductivity type of the emitter and the collector of the bipolar transistor, and
a third portion between the second portion and the emitter and including Ge, wherein a Ge concentration in the third portion varies with respect to distance between the second portion and the emitter.

In some examples of embodiment 9, the structure of embodiment 9 may be related to the structure of embodiments 1 such that embodiment 9 may be directly combined with any of embodiments 2 to 8.

### Embodiment 10:

The structure of embodiment 9, wherein the dopant includes one of boron (B) or phosphorous (P).

### Embodiment 11:

The structure of embodiment 9 or 10, wherein a profile of the Ge concentration in the first portion impedes diffusion of the dopant from the doped region to the collector, and wherein a profile of the Ge concentration in the third portion impedes diffusion of the dopant from the doped region to the emitter.

### Embodiment 12:

The structure of one of embodiments 9 to 11, wherein the first portion and the third portion each include superlattice structures of semiconductor layers having different Ge concentrations.

### Embodiment 13:

The structure of one of embodiments 9 to 12, wherein the first portion and the third portion each include silicon germanium (SiGe) segments having a spiked Ge concentration profile between the second portion and the collector or the emitter.

### Embodiment 14:

The structure of one of embodiments 9 to 12, wherein the first portion and the third portion each include silicon germanium (SiGe) segments having a valleyed Ge concentration profile between the second portion and the collector or the emitter.

### Embodiment 15:

A method comprising:
forming a base region, wherein forming the base region includes:
forming a first portion on a first emitter/collector (E/C) terminal and including germanium (Ge), wherein a Ge concentration in the first portion varies with respect to distance from the first E/C terminal,
forming a second portion on the first portion and including Ge, and
forming a third portion between the second portion and a second E/C terminal and including Ge, wherein a Ge concentration in the third portion varies with respect to distance between the second portion and the second E/C terminal.

**In** some illustrative examples of embodiment 15, the second portion may further include a dopant having a different conductivity type from a conductivity type of the first E/C terminal and the second E/C terminal of the bipolar transistor.

**In** special illustrative examples herein, the dopant may include one of boron (B) or phosphorous (P).

**In** some illustrative examples of embodiment 15, the method may form a structure which may be a bipolar transistor structure and the first E/C terminal may comprise a collector of a bipolar transistor structure, the second E/C terminal may comprise an emitter of the bipolar transistor structure and the base region may comprise a base of the bipolar transistor structure.

In some illustrative examples of embodiment 15, the method may form a structure which structure may be a bipolar transistor structure and the first E/C terminal may be a collector of a bipolar transistor structure, the second E/C terminal may be an emitter of the bipolar transistor structure and the base region may be a base of the bipolar transistor structure.

### Embodiment 16:

The method of embodiment 15, wherein forming the second portion includes forming a doped region having a first conductivity type different from a second conductivity type of the first E/C terminal and the second E/C terminal.

### Embodiment 17:

The method of embodiment 16, wherein a profile of the Ge concentration in the first portion impedes diffusion of a dopant from the doped region to the first E/C terminal, and wherein a profile of the Ge concentration in the third portion impedes diffusion of the dopant from the doped region to the second E/C terminal.

### Embodiment 18:

The method of one of embodiments 15 to 17, wherein forming the first portion and forming third portion each include forming superlattice structures of semiconductor layers having different Ge concentrations.

### Embodiment 19:

The method of one of embodiments 15 to 18, wherein forming the first portion and forming the third portion each include forming silicon germanium (SiGe) segments having a spiked Ge concentration profile between the second portion and a respective E/C terminal.

### Embodiment 20:

The method of one of embodiments 15 to 19, wherein forming the first portion and forming the third portion each include forming silicon germanium (SiGe) segments having a valleyed Ge concentration profile between the second portion and a respective E/C terminal.

### Embodiment 21:

The method of one of embodiments 15 to 20, wherein the structure of one of embodiments 1 to 14 is formed.

## Claims

1. A structure comprising:
a base region including:
a first portion on a first emitter/collector (E/C) terminal and including germanium (Ge), wherein a Ge concentration in the first portion varies with respect to distance from the first E/C terminal,
a second portion on the first portion and including Ge, and
a third portion between the second portion and a second E/C terminal and including Ge, wherein a Ge concentration in the third portion varies with respect to distance between the second portion and the second E/C terminal.

2. The structure of claim 1, wherein the second portion includes a doped region having a first conductivity type different from a second conductivity type of the first E/C terminal and the second E/C terminal.

3. The structure of claim 2, wherein a profile of the Ge concentration in the first portion impedes diffusion of a dopant from the doped region to the first E/C terminal, and wherein a profile of the Ge concentration in the third portion impedes diffusion of the dopant from the doped region to the second E/C terminal.

4. The structure of one of claims 1 to 3, wherein the first portion and the third portion each include superlattice structures of semiconductor layers having different Ge concentrations.

5. The structure of claim 4, wherein each superlattice structure includes at least:
two first silicon germanium (SiGe) layers each having a first substantially uniform concentration of Ge, and
an intermediate layer between the two SiGe layers, including one of a silicon (Si) layer or an additional SiGe layer having a second substantially uniform concentration of Ge less than the first substantially uniform concentration of Ge.

6. The structure of claim 5, wherein the second portion includes a second silicon germanium layer with the first substantially uniform concentration of Ge.

7. The structure of one of claims 1 to 6, wherein the first portion and the third portion each include silicon germanium (SiGe) segments having one of a spiked Ge concentration profile between the second portion and a respective E/C terminal and a valleyed Ge concentration profile between the second portion and a respective E/C terminal.

8. The structure of one of claims 1 to 7, further comprising:
a base vertically between an emitter and a collector of a bipolar transistor, wherein the base includes the base region, the first E/C terminal comprises the collector and the second E/C terminal comprises the emitter,
wherein the first portion is arranged on the collector, and
wherein the second portion further includes a dopant having a different conductivity type from a conductivity type of the emitter and the collector of the bipolar transistor.

9. The structure of claim 8, wherein the dopant includes one of boron (B) or phosphorous (P).

10. A method comprising:
forming a base region, wherein forming the base region includes:
forming a first portion on a first emitter/collector (E/C) terminal and including germanium (Ge), wherein a Ge concentration in the first portion varies with respect to distance from the first E/C terminal,
forming a second portion on the first portion and including Ge, and
forming a third portion between the second portion and a second E/C terminal and including Ge, wherein a Ge concentration in the third portion varies with respect to distance between the second portion and the second E/C terminal.

11. The method of claim 10, wherein forming the second portion includes forming a doped region having a first conductivity type different from a second conductivity type of the first E/C terminal and the second E/C terminal.

12. The method of claim 11, wherein a profile of the Ge concentration in the first portion impedes diffusion of a dopant from the doped region to the first E/C terminal, and wherein a profile of the Ge concentration in the third portion impedes diffusion of the dopant from the doped region to the second E/C terminal.

13. The method of one of claims 10 to 12, wherein forming the first portion and forming third portion each include forming superlattice structures of semiconductor layers having different Ge concentrations.

14. The method of one of claims 10 to 13, wherein forming the first portion and forming the third portion each include forming silicon germanium (SiGe) segments having a spiked Ge concentration profile between the second portion and a respective E/C terminal.

15. The method of one of claims 10 to 14, wherein forming the first portion and forming the third portion each include forming silicon germanium (SiGe) segments having a valleyed Ge concentration profile between the second portion and a respective E/C terminal.
